# EUROPEAN PATENT APPLICATION

(11) **EP 4 803 916 A1**
(43) Date of publication of application: **09.09.2026**
(21) Application number: 25833307.9
(22) Date of filing: 27.06.2025
(51) Int. Cl.: G01R 31/64, G01R 21/06, G01R 31/382, G01R 31/52, G01R 31/56, G01R 27/26, G01R 19/165, G01R 31/36

(54) **BATTERY SYSTEM AND METHOD FOR DIAGNOSING CONDITION OF LINK CAPACITOR ACCORDING TO OPERATION OF PRECHARGE CIRCUIT**

(30) Priority: 01.07.2024 KR 20240086197
(71) Applicant: LG Energy Solution, Ltd., Seoul 07335 (KR)
(72) Inventor: KIM, Sookwon, Daejeon 34122 (KR)
(74) Representative: Plasseraud IP
(86) International application number: PCT/KR2025/009048
(87) International publication number: WO 2026/010248

(57) **Abstract**

The present disclosure relates to a battery system and a diagnose method of a link capacitor according to an operation of a pre-charge circuit, and a battery system according to the present disclosure includes a battery pack; two terminals connected to an external device including a link capacitor connected in parallel to the battery pack; a pre-charge circuit including a pre-charge resistor and a pre-charge relay connected in series between one terminal of the battery pack and one of two terminals; a main relay connected in parallel to the pre-charge circuit; and a battery management system (BMS) that measures the pack voltage of the battery pack and the link voltage between two terminals, controls the turn-on operations of the pre-charge relay and the main relay, calculates a reference power amount estimated to have been supplied to the pre-charge resistor during the driving time of the pre-charge circuit, calculates a target power amount supplied to the pre-charge resistor during the driving time of the pre-charge circuit, and diagnoses the state of the link capacitor as one of a plurality of fault states based on a comparison result of a target power amount and a threshold power amount according to the reference power amount and a comparison result of the pack voltage and the link voltage.

## Description

### [Technical Field]

### CROSS-REFERENCE TO RELATED APPLICATION

This application claims priority to and the benefit of Korean Patent Application No. 10-2024-0086197 filed in the Korean Intellectual Property Office on July 1, 2024, the entire contents of which are incorporated herein by reference.

The present disclosure relates to a battery system and a method for diagnosing a status of a link capacitor according to an operation of a pre-charge circuit.

### [Background Art]

Rechargeable batteries used in electric vehicles, etc., can be repeatedly charged and discharged. In a case of a battery system including a pre-charge circuit unit including a pre-charge resistor and a pre-charge relay, in an initial stage of driving the battery, a main relay may not be turned on from the beginning, and the pre-charge relay may be turned on first while the main relay is turned off. The main relay may be configured to be turned on only after a predetermined time has elapsed from when the pre-charge relay is turned on, thereby allowing the charge/discharge path to pass through the main relay.

When the pre-charge relay is turned on, a link capacitor (X-cap) connected in parallel to the battery pack may be charged while a surge current is limited by the pre-charge resistor. Additionally, when the operation of the pre-charge circuit unit ends and the pre-charge relay is turned off, the link capacitor (X-cap) may be discharged.

Through the operation of this pre-charge circuit unit, the current flows through the pre-charge resistor, so that no rush current occurs and an arcing is prevented from occurring when the main relay is turned on.

The pre-charge resistor provided in this pre-charge circuit unit may overheat and be damaged if the excessive current flows through the pre-charge resistor, and there is a problem that not only the pre-charge circuit but also the entire battery pack may be damaged due to the damage to the pre-charge resistor. Therefore, in order to protect the pre-charge resistor, it is necessary to diagnose various faults on the high-voltage lines connected to both terminals of the battery pack. It is also important to determine the type of the failure in the link capacitor connected to the high voltage line.

### [Disclosure]

### [Technical Problem]

The present disclosure provides a battery system capable of diagnosing the state of the link capacitor by driving the pre-charge circuit unit including the pre-charge relay and the pre-charge resistor, and a method for diagnosing the state of the link capacitor according to the operation of the pre-charge circuit.

### [Technical Solution]

According to one aspect of the disclosure, a battery system includes a battery pack; two terminals connected to an external device including a link capacitor connected in parallel to the battery pack; a pre-charge circuit including a pre-charge resistor and a pre-charge relay connected in series between one terminal of the battery pack and one of two terminals; a main relay connected in parallel to the pre-charge circuit; and a battery management system (BMS) that measures a pack voltage of the battery pack and a link voltage between the two terminals, controls a turn-on operations of the pre-charge relay and the main relay, calculates a reference power amount estimated to have been supplied to the pre-charge resistor during the driving time of the pre-charge circuit, calculates a target power amount supplied to the pre-charge resistor during a driving time of the pre-charge circuit, and diagnoses a state of the link capacitor as one of a plurality of fault states based on a comparison result of the target power amount and a threshold power amount according to the reference power amount and a comparison result of the pack voltage and the link voltage.

The BMS may calculate the reference power amount based on a capacitance of the link capacitor, a resistance value of the pre-charge resistor, and the pack voltage during the driving time of the pre-charge circuit.

A current sensor connected to one terminal of the pre-charge relay to measure a pre-charge current may be further included, wherein the BMS may calculate the target power amount based on the pack voltage and the pre-charge current flowing in the pre-charge relay during the driving time of the pre-charge circuit.

The plurality of fault states include at least one of an open fault in which at least one of two wires between both terminals of the link capacitor and two terminals is open, a short-circuit fault in which at least one of the both terminals of the link capacitor is grounded, and a load failure in which a capacitance value of the link capacitor is smaller than or larger than a predetermined reference capacitance range, if the status of the link capacitor is diagnosed as one of the plurality of fault states, the BMS may turn off the pre-charge relay and the main relay.

If the target power amount is less than a first threshold power amount that is less than the reference power amount, and the link voltage is outside a predetermined reference voltage range based on the pack voltage, the BMS may diagnose the status of the link capacitor as the open fault,
If the target power amount is less than a first threshold power amount that is less than the reference power amount, and the link voltage is within a predetermined reference voltage range based on the pack voltage, the BMS may diagnose the status of the link capacitor as the load failure, and diagnoses that the capacitance of the link capacitor is smaller than the lower limit of the reference capacitance range.

If the target power amount is within a range of less than the reference power amount and greater than or equal to a first threshold power amount less than the reference power amount, the BMS may diagnose the status of the link capacitor as the load failure.

If the link voltage is within a predetermined reference voltage range based on the pack voltage, the BMS may diagnose that the capacitance of the link capacitor is less than the lower limit of the reference capacitance range.

If the link voltage is outside of a predetermined reference voltage range based on the pack voltage, the BMS may diagnose that the capacitance of the link capacitor is greater than the upper limit of the reference capacitance range.

According to another aspect of the disclosure, a method for diagnosing a status of a link capacitor performed by a battery system, which includes a battery pack, two terminals connected to an external device including a link capacitor connected in parallel to the battery pack, a pre-charge circuit including a pre-charge resistor and a pre-charge relay connected in series between one terminal of the battery pack and one of the two terminals, a main relay connected in parallel to the pre-charge circuit, and a battery management system (BMS) controlling turn-on operations of the pre-charge relay and the main relay, includes measuring a pack voltage of the battery pack; measuring a link between the two terminals; calculating a reference power amount estimated to have been supplied to the pre-charge resistor during a driving time of the pre-charge circuit; calculating a target power amount supplied to the pre-charge resistor during the driving time of the pre-charge circuit; and diagnosing a state of the link capacitor as one of a plurality of fault states based on a comparison result between the critical power amount according to the reference power amount and the target power amount and a comparison result between the pack voltage and the link voltage,

Calculating the reference power amount based on a capacitance of the link capacitor, a resistance value of the pre-charge resistor, and the pack voltage during the driving time of the pre-charge circuit may be further included.

Measuring a pre-charge current being connected to one terminal of the pre-charge relay; and calculating the target power amount based on the pack voltage and the pre-charge current flowing in the pre-charge relay during the driving time of the pre-charge circuit may be further included.

The plurality of fault states may include at least one of an open fault in which at least one of two wires between both terminals of the link capacitor and two terminals is open, a short-circuit fault in which at least one of the both terminals of the link capacitor is grounded, and a load failure in which a capacitance value of the link capacitor is smaller than or larger than a predetermined reference capacitance range, diagnosing the status of the link capacitor as one of the plurality of fault states may include turning off the pre-charge relay and the main relay when the state of the link capacitor is diagnosed as one of the plurality of fault states.

If the target power amount is less than a first threshold power amount that is less than the reference power amount, and the link voltage is out of a predetermined reference voltage range based on the pack voltage, diagnosing the state of the link capacitor as the open fault may be further included.
if the target power amount is less than a first threshold power amount that is less than the reference power amount, and the link voltage is within a predetermined reference voltage range based on the pack voltage, diagnosing the status of the link capacitor as the load failure, and diagnosing the capacitance of the link capacitor as being smaller than the lower limit of the reference capacitance range may be further included.

If the target power amount is within a range of less than the reference power amount and greater than or equal to a first threshold power amount less than the reference power amount, diagnosing the status of the link capacitor as the load failure may be further included.

If the link voltage is within a predetermined reference voltage range based on the pack voltage, diagnosing that the capacitance of the link capacitor is smaller than the lower limit of the reference capacitance range may be further included.

If the link voltage is outside of a predetermined reference voltage range based on the pack voltage, diagnosing that the capacitance of the link capacitor is greater than the upper limit of the reference capacitance range may be further included.

### [Advantageous Effects]

According to the present disclosure, in order to protect the pre-charge resistor, the state of the link capacitor may be diagnosed as one of a plurality of fault states such as an open fault, a short-circuit fault, and a load failure by comparing a reference power amount estimated to have been supplied to the pre-charge resistor with a target power amount actually supplied, so that the battery system may identify the type of the fault that has occurred in the link capacitor. In addition, the status of the link capacitor may be diagnosed more specifically based on the comparison results between the reference power amount and the target power amount and the comparison results between the link voltage and the pack voltage.

According to the present disclosure, by automatically detecting an open circuit fault in a high-voltage line and then taking countermeasures before an accident occurs to a worker, secondary safety accidents may be prevented, and cause analysis may be facilitated when a problem occurs.

According to the present disclosure, a load failure such as a vehicle mis-assembly may be automatically detected, and a worker assembling the vehicle into the battery system is notified of the vehicle mis-assembly, thereby enabling the link stage of the vehicle to be inspected before a secondary accident occurs.

### [Description of the Drawings]

FIG. 1 is a block diagram schematically illustrating a battery system according to one embodiment.
FIG. 2 is a view for explaining a state in which an open circuit fault occurs in a link capacitor in a battery system illustrated in FIG. 1.
FIG. 3 is a view for explaining a state in which a load failure occurs in a link capacitor in a battery system illustrated in FIG. 1.
FIG. 4 is a view for explaining a state in which a short-circuit failure occurs in a link capacitor in a battery system illustrated in FIG. 1.
FIG. 5 is a flowchart of a method for diagnosing a status of a link capacitor according to an operation of a pre-charge circuit according to one embodiment.

### [Mode for Invention]

Hereinafter, embodiments disclosed in the present specification will be described in detail with reference to the accompanying drawings. In the present specification, the same or similar components will be denoted by the same or similar reference numerals, and an overlapped description thereof will be omitted. The terms "module" and "unit" for components used in the following description are used only in order to easily make a specification. Therefore, these terms do not have meanings or roles that distinguish them from each other in themselves. Further, in describing embodiments of the present specification, when it is determined that a detailed description of the well-known art associated with the present disclosure may obscure the gist of the present disclosure, it will be omitted. In addition, the accompanying drawings are provided only in order to allow embodiments disclosed in the present specification to be easily understood and are not to be interpreted as limiting the spirit disclosed in the present specification, and it is to be understood that the present disclosure includes all modifications, equivalents, and substitutions without departing from the scope and spirit of the present disclosure.

Terms including ordinal numbers such as first, second, and the like will be used only to describe various components, and are not interpreted as limiting these components. The terms are only used to differentiate one component from other components.

It will be further understood that terms "comprise" or "have" used in the present specification specify the presence of stated features, numerals, steps, operations, components, parts, or a combination thereof, but do not preclude the presence or addition of one or more other features, numerals, steps, operations, components, parts, or a combination thereof.

In a configuration for controlling other configurations in a specific control condition among configurations according to an embodiment, a program implemented as a set of instruction words embodying a control algorithm necessary to control other configurations may be installed. The control configuration may generate output data by processing input data and stored data according to the installed program. The control configuration may include a nonvolatile memory to store the programs and a memory to store the data.

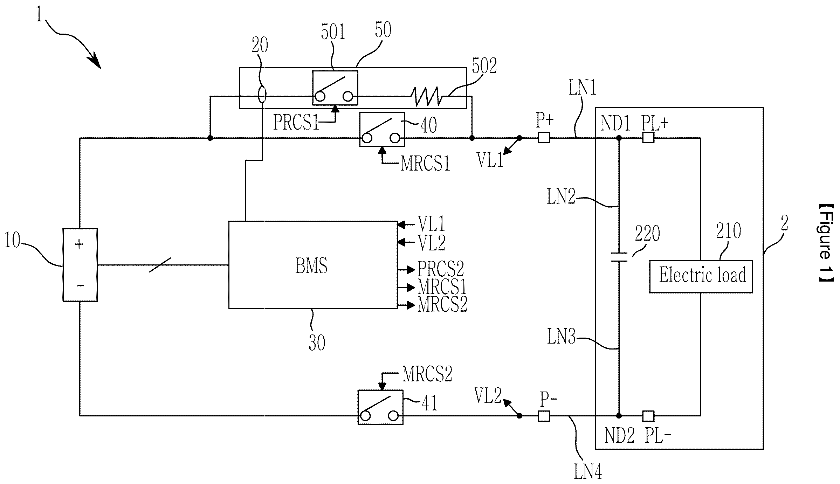

FIG. 1 is a block diagram schematically illustrating a battery system according to one embodiment.

Referring to FIG. 1, the battery system 1 may include a battery pack 10, a current sensor 20, a battery management system (BMS) 30, a main relay (40, 41), and a pre-charge circuit unit 50.

The battery pack 10 may include two or more battery cells connected in series, a plurality of connected in series battery cells in which two or more battery cells are connected in parallel, or two or more battery cells connected in parallel.

The battery system 1 may be connected to an external device 2. The external devices 2 may include a load such as inverters and converters and a charging device. When the external device 2 is the charger, two terminals (P+, P-) of the battery system 1 may be connected to the charger and charged by receiving a power from the charger. When the external device 2 is the load, two terminals (P+, P-) of the battery system 1 are connected to the load so that the power supplied by the battery pack 10 may be discharged through the load.

The terminal (P+) of the battery system 1 may be connected to one terminal of the external device 2, and the terminal (P-) of the battery system 1 may be connected to the other terminal of the external device 2. In the following, the external device 2 is assumed to be a vehicle, but this is for convenience of explanation and the disclosure is not limited thereto.

The external device 2 may include an electric load 210, a link capacitor 220, and terminals PL+ and PL-. The high voltage HV line of the battery pack 10 can be connected to the electric load 210 and the link capacitor 220 through two terminals P+ and P- of the battery system 1.

The link capacitor 220 mat be connected in parallel to each of the battery pack 10 and the electric load 210. One terminal of the electric load 210 and the link capacitor 220 may be connected to the terminal P+ and the terminal PL+, and the other terminal of the electric load 210 and the link capacitor 220 may be connected to the terminal P- and the terminal PL-. The electric load 210 may include an inverter, a converter, etc. A node ND1 connected to one end of the link capacitor 220 can be connected to a terminal PL+, and a node ND2 connected to the other end of the link capacitor 220 can be connected to a terminal (PL-). The terminal P+ and the node ND1 may be connected by a wire LN1, and one terminal of the node ND1 and the link capacitor 220 may be connected by a wire LN2. The other terminal of the node ND2 and the link capacitor 220 may be connected by a wiring LN3, and the terminal P- and the node ND2 may be connected by a wiring LN4.

The link capacitor 220 may be included in the link terminal. The link may collectively refer to a plurality of wires for electrically connecting between the electric load 210 and two terminals P+ and P- of the battery system 1. For example, the link terminal may include wires LN1 to LN4 between two terminals P+ and P- of the link capacitor 220 and two terminals of the battery system 1.

The link capacitor 220 may be implemented as a single capacitor or a combination of multiple capacitors, and may also be implemented as a combination of passive and active components. The capacitance of the link capacitor 220 is not limited and may be selected as a predetermined value according to the pack voltage of the battery pack 10.

One terminal of the main relay 40 and 41 is connected to the battery pack 10, and the other terminal of the main relay 40 and 41 is connected to at least one component in the external device 2. The closing and opening of the main relay 40 and 41 may be controlled according to the main relay control signal MRCS1 and MRCS2 supplied from the BMS 200.

The pre-charge circuit unit 50 may include a pre-charge relay 501 and a pre-charge resistor 502. The pre-charge circuit unit 50 may be connected in parallel to the main relay 40. One terminal of the pre-charge circuit unit 50 may be connected to the positive terminal of the battery pack 10 and one terminal of the main relay 40. The other terminal of the pre-charge circuit unit 50 may be connected to the other terminal of the main relay 40 and the positive electrode P+ of the battery system 1. The closing and opening of the pre-charge relay 501 may be controlled according to the pre-charge relay control signal PRCS1 supplied from the BMS 200.

The pre-charge circuit unit 50 may perform a pre-charge. Specifically, when the pre-charge relay 501 is turned on, the link capacitor 220 is slowly precharged by receiving a microcurrent reduced by the pre-charge resistor 502, so that the voltage supplied from the battery pack 10 may be charged to the link capacitor 220. Additionally, when the pre-charge relay 501 is turned off, the link capacitor 220 may be discharged.

Therefore, when the pre-charge relay 501 is turned on before the main relay 40 is turned on, and then the main relay 40 is turned on, the surge current due to the connection with the external device 2 may be reduced, and the battery pack 10 may perform a charge/discharge operation with respect to the external device 2.

The BMS 30 may control the turn-on operation of the pre-charge relay and the main relay according to the main relay control signals MRCS1 and MRCS2 and the pre-charge relay control signal PRCS1.

The current sensor 20 is connected in series to the current path between the positive terminal of the battery pack 10 and one terminal of the pre-charge relay 501. The current sensor 20 may measure the current(hereinafter, "a pre-charge current") flowing in the pre-charge relay 501 and transmit the measurement result to the BMS 30. The BMS 30 may derive the pre-charge current based on the signal received from the current sensor 20.

The BMS 30 may measure the pack voltage of the battery pack 10 and the voltage (hereinafter, "a link voltage") between two terminals P+ and P- of the battery system 1. The BMS 30 may receive a signal representing the positive voltage of the battery pack 10 and a signal representing the negative voltage of the battery pack 10. The BMS 30 may measure the pack voltage of the battery pack 10 based on the signal representing the positive voltage of the battery pack 10 and the signal representing the negative voltage of the battery pack 10. The BMS 30 may receive a signal VL1 indicating the voltage of the positive terminal P+ of the battery system 1 and a signal VL2 indicating the voltage of the negative terminal P- of the battery system 1. The BMS 30 may measure the link voltage based on the signal VL1 indicating the voltage of the positive terminal P+ of the battery system 1 and the signal VL2 indicating the voltage of the negative terminal P- of the battery system 1.

The BMS 30 may repeatedly measure the pack voltage, the link voltage, and the pre-charge current of the battery pack 10 in a predetermined period.

The time for which the pre-charge circuit unit 50 operates may be referred to as an operating time of the pre-charge circuit unit 50.

The start time of the driving time of the pre-charge circuit unit 50 may be s first timing point when the BMS 30 turns on the pre-charge relay 501. The first timing point may be a time when the BMS 30 outputs a pre-charge relay control signal PRCS1 that controls the pre-charge relay 501 to be turned on. The BMS 30 may start the driving of the pre-charge circuit unit 50 by controlling the main relay 40 to be turned off, controlling the main relay 41 to be turned on, and controlling the pre-charge relay 501 to be turned on. Accordingly, the voltage of the battery pack 10 may be applied to the electric load 210 and link capacitor 220 through the pre-charge circuit unit 50. In addition, in this case, since the current flows through the pre-charge circuit unit 50, the current may also flow through the pre-charge resistor 502.

The finishing point of the driving time of the pre-charge circuit unit 50 may be a second timing point when the BMS 30 turns off the pre-charge relay 501 after the first timing point. The second timing point may be a timing point when the BMS 30 outputs a pre-charge relay control signal PRCS1 that controls the pre-charge relay 501 to be turned off. The BMS 30 may control the pre-charge relay 501 to be turned off at the second timing point to terminate the operation of the pre-charge circuit unit 50. Accordingly, the voltage of the battery pack 10 may not be applied to the pre-charge circuit unit 50 and the link capacitor 220. Also, in this case, since no current flows through the pre-charge circuit unit 50, no current may also flow through the pre-charge resistor 502.

The BMS 30 may calculate the time difference between the first timing point at which the pre-charge relay 501 is turned on and the second timing point at which the pre-charge relay 501 is turned off as the operating time of the pre-charge circuit unit 50.

The BMS 30 may calculate the amount of the power (hereinafter, "a reference power amount") estimated to have been supplied to the pre-charge resistor 502 during the operating time of the pre-charge circuit unit 50. The reference power amount may be an estimated power amount in a normal state where the link capacitor 220 does not correspond to all of the plurality of fault states. The BMS 30 may calculate the amount (hereinafter, "a target power amount")of the power supplied to the pre-charge resistor 502 during the operating time of the pre-charge circuit unit 50. The target power amount may be an actual power amount supplied to the pre-charge resistor 502 during the driving time of the pre-charge circuit unit 50.

After the operating time of the pre-charge circuit unit 50 ends, the BMS 30 may diagnose the status of the link capacitor 220 as one of the plurality of failure states based on the comparison result between the threshold power amount according to the reference power amount and the target power amount and the comparison result between the pack voltage of the battery pack 10and the link voltage.

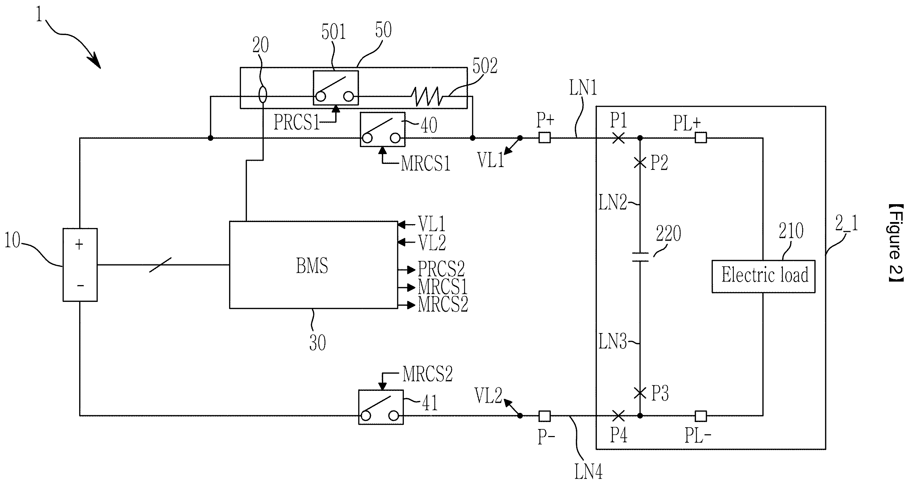

The plurality of fault states may include at least one of an open fault, a short circuit fault, and a load failure. The open fault may be a state in which at least one of the wires LN1 to LN4 between two terminals of the link capacitor 220 and two terminals P+ and P- of the of the battery system 1 is opened. The short circuit fault may be a state where at least one of two terminals of the link capacitor 220 is grounded. The load failure may be a state in which the capacitance value of the link capacitor 220 is smaller or larger than a predetermined reference capacitance range. Hereinafter, each of the plurality of fault states will be described as an example with reference to FIG. 2 to FIG. 4.

FIG. 2 is a view for explaining a state in which an open fault occurs in a link capacitor in a battery system illustrated in FIG. 1.

The external device 2_1 illustrated in FIG. 2 may represent an example of a state in which the open fault has occurred in the link capacitor 220 included in the external device 2 illustrated in FIG. 1. Below, the descriptions of the battery systems 1 and the external devices 2 that overlap the previous descriptions may be omitted.

Referring to FIG. 2, the external device 2_1 includes an electric load 210, a link capacitor 220, and terminals PL and PL-, and at least one point (e.g., O1) among a plurality of points O1 to O4 connected to each of both terminals of the link capacitor 220 may be opened. In one embodiment, as shown in FIG. 2, the open may be defined as a state in which at least one of the wires LN1 to LN4 between two terminals P+ and P- of the link capacitor 220 and two terminals P+ and P- of the battery system 1 is disconnected and opened.

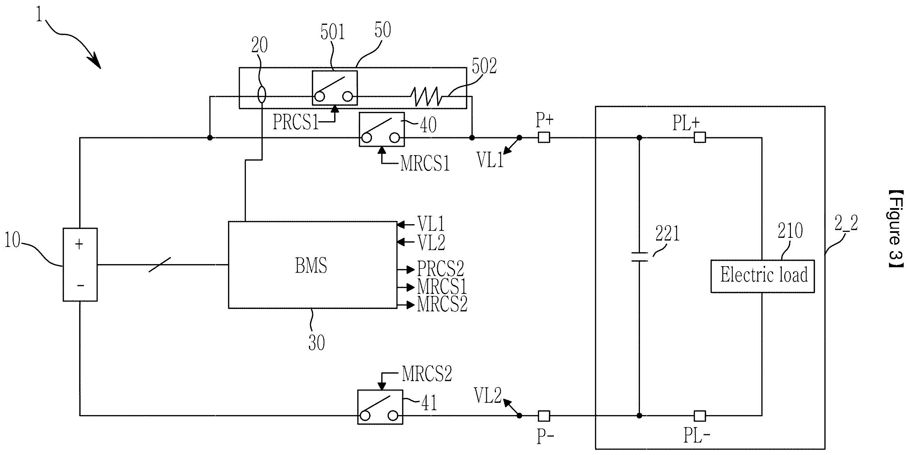

FIG. 3 is a view for explaining a state in which a load failure occurs in a link capacitor in a battery system illustrated in FIG. 1.

The external device (2_2) illustrated in FIG. 3 may represent an example of a state in which a load failure occurs in the link capacitor 220 included in the external device 2 illustrated in FIG. 1. Below, the descriptions of the battery systems 1 and the external devices 2 that overlap the previous descriptions may be omitted.

Referring to FIG. 3, the external device 2_2 includes an electric load 210, a link capacitor 221, and terminals PL and, PL-, and the link capacitor 221 may be another example of the link capacitor 220 illustrated in FIG. 1. The capacitance value of the link capacitor 221 may be smaller than a lower limit of a predetermined reference capacitance range or larger than an upper limit of the reference capacitance. The predetermined reference capacitance range may be a predetermined range for a power supply from the battery pack 10 to the electric load 210 to be performed normally. Here, the lower limit of the reference capacitance range may be a first level, and the upper limit of the reference capacitance range may be a second level. The capacitance value of the link capacitor 221 may be lower than the first level or higher than the second level.

When connecting the battery system 1 to the external device 2, the link capacitor having the appropriate capacitance is required. The load failure may include not only a case where the capacitance of the link capacitor is out of the standard capacitance range, but also a case where the battery system 1 is assembled to the wrong vehicle, a case where the link capacitor is broken, a case where the battery system 1 and the external device 2 are incorrectly assembled, such as when some of the multiple cables for connecting the battery system 1 and the external device 2 are not connected. In addition, the load failure may also include a defect (hereinafter, "a defect in a pack connection environment setting") in setting the connection environment between the battery system 1 and the external device 2.

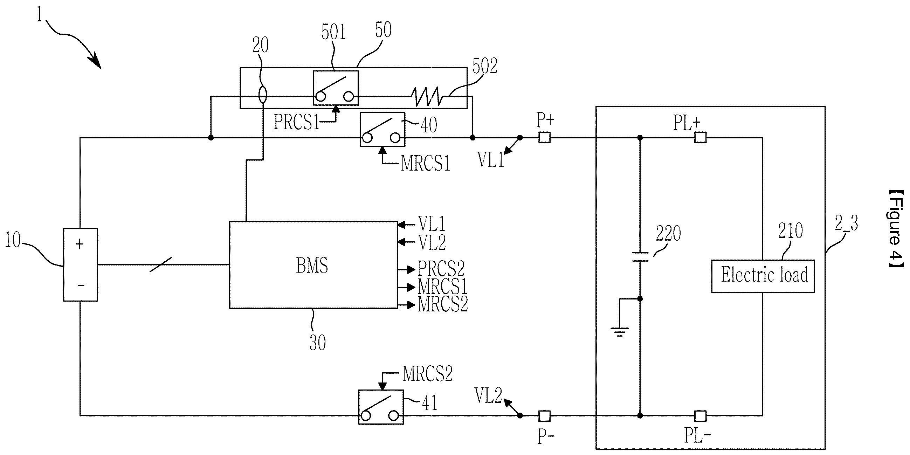

FIG. 4 is a view for explaining a state in which a short failure occurs in a link capacitor in a battery system illustrated in FIG. 1.

The external device 2_3 illustrated in FIG. 4 may represent an example of a state in which a short failure has occurred in the link capacitor 220 included in the external device 2 illustrated in Fig. 1. Below, the descriptions of the battery systems 1 and the external devices 2 that overlap the previous descriptions may be omitted.

Referring to FIG. 4, the external device 2_3 includes an electric load 210, a link capacitor 220, and terminals PL+ and PL-, and one terminal of the link capacitor 220 may be grounded to a ground (GND) voltage. In one embodiment, as illustrated in FIG. 4, the state in which at least one of two terminals of the link capacitor 220 is grounded may be considered a short circuit fault.

The BMS 30 may calculate a reference power amount based on the capacitance of the link capacitor 220, the resistance value of the pre-charge resistor 502, and the pack voltage of the battery pack 10 during the operating time of the pre-charge circuit unit 50.

For example, the BMS 30 may calculate the reference power amount according to [Equation 1] below. $W 1 = {\int }_{T 1}^{T 2} Vb \left(T1\right) ∗ \left(\left(\frac{Vb \left(T1\right)}{R}\right)∗{e}^{- \frac{t}{RC}}\right) dt$

Here, W1 is the reference power amount, T1 is the start time of the driving time of the pre-charge circuit unit 50, T2 is the end time of the driving time of the pre-charge circuit unit 50, Vb (T1) is the pack voltage of the battery pack 10 measured at the time point T1, R is the resistance value of the pre-charge resistor 502, and C is the capacitance of the link capacitor 220.

When the pre-charge relay 501 is turned on and the main relay 40 is turned off, an RC circuit including the pre-charge resistor 502 and the link capacitor 220 and using the battery pack 10 as a voltage source may be formed. The BMS 30 may estimate the reference power amount by multiplying the output value of the current calculation formula for the link capacitor corresponding to the RC circuit during the operating time of the pre-charge circuit unit 50 and the pack voltage of the battery pack 10.

In addition, the BMS 30 may calculate the target power amount based on the pack voltage of the battery pack 10 and the pre-charge current flowing in the pre-charge relay 501 during the operating time of the pre-charge circuit unit 50.

For example, the BMS 30 may calculate the reference power amount according to [Equation 2] below. $W 2 = {\int }_{T 1}^{T 2} Vb \left(t\right) ∗ {I}_{r} \left(t\right) dt$

Here, W2 is the target power amount, T1 is the start time of the driving time of the pre-charge circuit unit 50, T2 is the end time of the driving time of the pre-charge circuit unit 50, Vb(t) is the pack voltage of the battery pack 10, and Ir(t) is the pre-charge current.

The BMS 30 may compare the threshold power amount according to the reference power amount and the target power amount. Additionally, the BMS 30 can compare the pack voltage of the battery pack 10 and the link voltage.

Below, the operation of the BMS 30 comparing the target power amount with the threshold power amount according to the reference power amount and comparing the pack voltage and the link voltage is described.

The threshold power amount according to the reference power amount to be compared with the target power amount may include the reference power amount, the first threshold power amount less than the reference power amount, the second threshold power amount exceeding the reference power amount, etc. For example, the first threshold power amount may be 50% of the reference power amount, i.e. half of the reference power amount. Also, for example, the second threshold power amount may be 200% of the reference power amount, i.e. twice the reference power amount.

Hereinafter, for convenience of explanation, the first threshold power amount is described as 50% of the reference power amount, and the second threshold power amount is described as 200% of the reference power amount, but this is only an example and the disclosure is not limited thereto. The first threshold power amount may be a minimum reference for the power amount below the reference power amount, and the second threshold power amount may be a maximum reference for the power amount exceeding the reference power amount.

The BMS 30 can determine whether the target power amount is less than the first threshold power amount, within a range that is greater than or equal to the first threshold power amount and less than the reference power amount, within a range that is greater than or equal to the reference power amount and less than the second threshold power amount, or greater than or equal to the second threshold power amount.

Additionally, the BMS 30 can determine whether the link voltage is within a predetermined reference voltage range based on the pack voltage of the battery pack 10. For example, the predetermined reference voltage range based on the pack voltage may be a voltage range that is 90% or more of the pack voltage of the battery pack 10. Hereinafter, for convenience of explanation, the reference voltage range is described as a voltage range that is 90% or more of the pack voltage of the battery pack 10, but this is only an example and the disclosure is not limited thereto. The reference voltage range may be a predetermined range based on the pack voltage.

If the target power amount is less than the first threshold power amount that is less than the reference power amount and the link voltage is outside the predetermined reference voltage range based on the pack voltage of the battery pack 10, the BMS 30 may diagnose the status of the link capacitor 220 as the open fault.

Referring to FIG. 2, when the open fault occurs, the link capacitor 220 and the battery system 1 are not connected and both terminals of the battery pack 10 are opened, so that no current may flow to the pre-charge resistor 502.

Accordingly, the target power amount, which is the amount of the power actually supplied to the pre-charge resistor 502 in the battery system 1 illustrated in FIG. 2, may be less than the first threshold power amount, and the link voltage may be less than 90% of the pack voltage of the battery pack 10.

Using this, the BMS 30 may diagnose the status of the link capacitor 220 as the open fault if the target power amount is less than the first threshold power amount and the link voltage is less than 90% of the pack voltage of the battery pack 10.

In this way, if the target power amount is less than 50% of the reference power amount and the link voltage is less than 90% of the pack voltage of the battery pack 10, the BMS 30 may control the main relay 40 and the pre-charge relay 501 to turn off. If the open circuit fault occurs, the current of the battery pack 10 may leak from two terminals P+ and P- of the battery system 1, which may cause an electric shock to users such as workers. Therefore, when the open fault occurs, the BMS 30 may prevent a safety accident for the user by turning off the main relay 40 and the pre-charge relay 501.

If the target power amount is less than the first threshold power amount and the link voltage is within a predetermined reference voltage range based on the pack voltage of the battery pack 10, the BMS 30 may diagnose the status of the link capacitor 220 as the load failure.

Referring to FIG. 3, when the load failure occurs, the capacitance value of the link capacitor 221 may be smaller than the lower limit of the predetermined reference capacitance range or larger than the upper limit of the reference capacitance range.

For example, if the target power amount is less than 50% of the reference power amount and the link voltage is more than 90% of the pack voltage of the battery pack 10, the BMS 30 may diagnose that the capacitance of the link capacitor 221 is less than a predetermined level or is a pack connection environment setting failure.

If the target power amount is within the range that is less than the reference power amount and greater than the first threshold power amount, the BMS 30 may diagnose the status of the link capacitor 221 as the load failure. In addition, If the target power amount is within the range that is less than the reference power amount and greater than the first threshold power amount, the BMS 30 may determine whether the capacitance value of the link capacitor 221 corresponding to the load failure exceeds or is less than a predetermined reference capacitance range based on the result of comparing the link voltage with the pack voltage of the battery pack 10.

If the target power amount is within the range that is less than the reference power amount and greater than or equal to the first threshold power amount, and the link voltage is within the predetermined reference voltage range based on the pack voltage of the battery pack 10, the BMS 30 determines the status of the link capacitor 221 as the load failure, and may diagnose that the capacitance value of the link capacitor 221 is smaller than the lower limit of the predetermined reference capacitance range. For example, if the target power is within the range of 50% to 100% of the reference power amount and the link voltage is 90% or more of the pack voltage of the battery pack 10, the BMS 30 may determine that the capacitance of the link capacitor 221 is less than a predetermined first level or the pack connection environment setting failure.

If the target power amount is within a range that is less than the reference power amount and greater than or equal to the first threshold power amount, and the link voltage is outside a predetermined reference voltage range based on the pack voltage of the battery pack 10, the BMS 30 may determine the status of the link capacitor 221 as the load failure and diagnose that the capacitance value of the link capacitor 221 is greater than the upper limit of the predetermined reference capacitance range. For example, if the target power is within the range of 50% to 100% of the reference power amount and the link voltage is less than 90% of the pack voltage of the battery pack 10, the BMS 30 may determine that the capacitance of the link capacitor 221 is greater than a predetermined second level or the pack connection environment setting failure.

As described above, if the status of the link capacitor 221 is diagnosed as the load failure, the BMS 30 may control the main relay 40 and the pre-charge relay 501 to turn off. If the load failure occurs, the pre-charge of the pre-charge circuit unit 50 may not be performed properly. Therefore, when the BMS 30 diagnoses the load failure, the BMS 30 may prevent a risk due to the pre-charge not being performed properly by turning off the main relay 40 and the pre-charge relay 501.

Meanwhile, if the target power amount is greater than or equal to the reference power amount and less than the second threshold power amount, the BMS 30 may diagnose the status of the link capacitor (220, referring to FIG. 1) as a normal. For example, if the target power is within the range of 100% to 200% of the reference power amount, the BMS 30 may diagnose the state of the link capacitor 220 as a normal in which the pre-charge is normally performed during the driving time of the pre-charge circuit unit 50.

If the target power amount is greater than or equal to the second threshold power amount, the BMS 30 may diagnose that a short failure has occurred.

Referring to FIG. 4, when the short circuit fault occurs, at least one of two terminals of the link capacitor 220 is connected to a ground, and the amount of the power greater than the amount of the power allowed to the pre-charge resistor 502 may be supplied. In this case, the target power amount, which is the actual power amount supplied to the pre-charge resistor 502, may be included in the range equal to or greater than the second threshold power amount set as twice the reference power amount.

Using this, if the target power amount is greater than or equal to the second threshold power amount, the BMS 30 may diagnose the status of the link capacitor 220 as the short- failure.

In this way, if the target power amount is 200% or more of the reference power amount, the BMS 30 may control the pre-charge relay 501 to turn off. If the short circuit fault occurs, the pre-charge resistor may be damaged or the battery pack 10 may be grounded, causing the battery pack 10 to discharge. Therefore, when the short failure occurs, the BMS 30 may turn off the main relay 40 and the pre-charge relay 501 so that no more power is supplied to the pre-charge resistor 502.

In another embodiment, if the target power amount is 200% or more of the reference power amount, the BMS 30 may control the main relay 40 or the pre-charge relay 501 to turn off.

The BMS 30 may include a display device that displays the diagnostic result indicating the fault state determined as the state of the link capacitor 220 among the plurality of fault states by using at least one of symbols, numbers, and codes, and a notification unit (not shown) equipped with at least one of speaker devices that outputs the diagnostic result as an audio signal. The BMS 30 may output the diagnosis result through the display device and/or a speaker device via the notification unit (not shown). For example, if the status of the link capacitor 220 is diagnosed as the load failure, the BMS 30 may output that the load failure has occurred and whether the capacitance value of the link capacitor 220 is smaller than or larger than a predetermined standard capacitance range as a diagnosis result through the notification unit (not shown).

When the diagnostic results are output through the notification unit (not shown), the users such as the workers may check the link stage of the vehicle. For example, if as the diagnostic result of the link stage, some of the multiple cables for the connection are not connected, the missing cables may be properly connected.

Below, the trend of the target power and the link voltage for each of plurality of fault states is described.

When the driving time of the pre-charge circuit unit 50 ends, a signal (a pre-charge process complete) indicating the end of the driving time of the pre-charge circuit unit 50 may be turned on with a True value. When the driving time of the pre-charge circuit unit 50 ends, in the normal state, the target power amount E_PL may be almost the same as the reference power amount (Energy Prediction), and the link voltage U_DC_Link may be almost the same as the pack voltage U Battery Pack of the battery pack 10.

When the driving time of the pre-charge circuit unit 50 ends and the short circuit fault occurs in the link capacitor 220, a signal (a pre-charge short circuit) indicating that the short circuit fault has occurred may be turned on with a True value. In this case, the target power amount E(SC) exceeds the second threshold power amount (Pre-charge Energy: Maximum Limit), and the link voltage U_DC_Link(SC) may be lowered to 40% of the pack voltage U Battery Pack of the battery pack 10.

When the driving time of the pre-charge circuit unit 50 ends and the load failure (Parallel load) occurs in the link capacitor 220, a signal (Pre-charge process complete) indicating the end of the driving time of the pre-charge circuit unit 50 and a signal (Parallel load) indicating that the load failure has occurred may be turned on with a True value. In this case, the target power amount E (Open Loop) is less than the first threshold power amount (Pre-charge Energy: Minimum Limit), and the link voltage U_DC_Link may be almost the same as the pack voltage U Battery Pack of the battery pack 10.

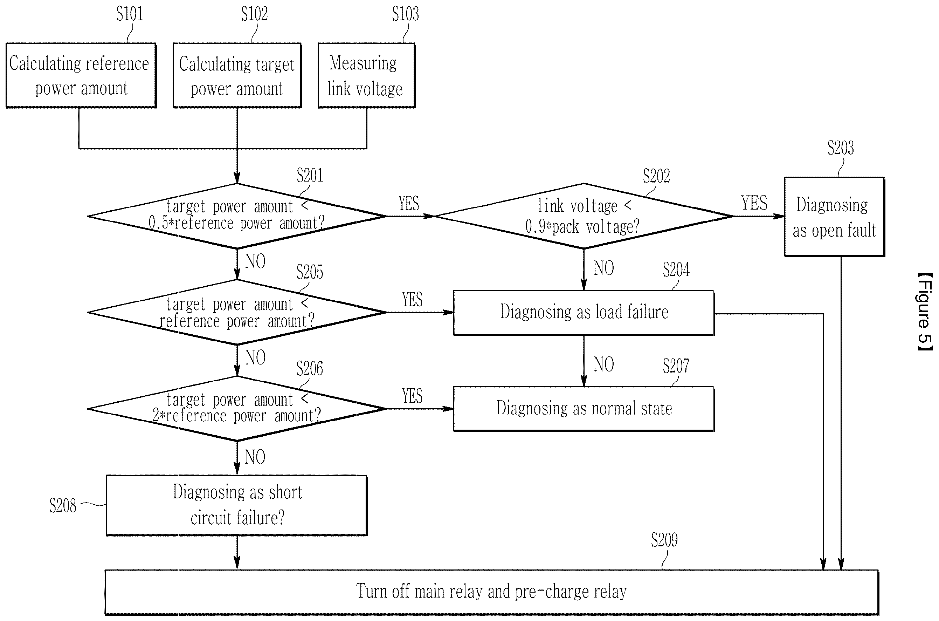

FIG. 5 is a flowchart of a method for diagnosing a status of a link capacitor according to an operation of a pre-charge circuit according to one embodiment.

Below, in the description of the battery system 1, any part that overlaps the previous description may be omitted.

Referring to FIG. 5, the BMS 30 may calculate a reference power amount based on the capacitance of the link capacitor 220, the resistance value of the pre-charge resistor 502, and the pack voltage of the battery pack 10 during the driving time of the pre-charge circuit unit 50 (S101).

The BMS 30 may calculate the target power amount based on the pack voltage of the battery pack 10 and the pre-charge current flowing in the pre-charge relay 501 during the driving time of the pre-charge circuit unit 50 (S102).

The BMS 30 may measure the link voltage based on a signal VL1 indicating the voltage of the positive terminal P+ of the battery system 1 and a signal VL2 indicating the voltage of the negative terminal P- of the battery system 1 (S103). Additionally, the BMS 30 can measure the pack voltage of the battery pack 10 based on a signal representing the positive voltage of the battery pack 10 and a signal representing the negative voltage of the battery pack 10.

The BMS 30 may determine whether the target power amount is less than 50% of the reference power amount (S201). Below, 50% of the reference power amount is an example of the first threshold power.

In the step (S201), if the target power amount is less than 50% of the reference power amount (Yes, in the step (S201)), the BMS 30 may determine whether the link voltage is less than 90% of the pack voltage of the battery pack 10 (S202). Below, the range which is greater than 90% of the pack voltage is an example of a predetermined reference voltage range.

In the step (S202) if the link voltage is less than 90% of the pack voltage of the battery pack 10 (Yes, at the step (S202)), the BMS 30 may diagnose the status of the link capacitor 220 as an open fault (S203).

In the step (S202) if the link voltage is more than 90% of the pack voltage of the battery pack 10 (NO at the step (S202)), the BMS 30 may diagnose the status of the link capacitor (221, referring to FIG. 3) as a load failure (S204). The load failure in the step (S204) may be due to the capacitance of the link capacitor (221, referring to FIG. 3) being less than the lower limit of the reference capacitance range, or a pack connection environment setting fault.

In the step (S201), if the target power amount is greater than 50% of the reference power amount (No at the step (S201)), the BMS 30 may determine whether the target power amount is less than the reference power amount (S205).

In the step (S205), if the target power amount is less than the reference power amount (Yes, at the step (S205)), the BMS 30 may diagnose the status of the link capacitor (221, referring to FIG. 3) as a load failure (S204). If the target power is within the range of 50% to 100% of the reference power amount and the link voltage is 90% or more of the pack voltage of the battery pack 10, the BMS 30 may determine that the capacitance of the link capacitor (221, referring to FIG. 3) is smaller than the lower limit of the reference capacitance range or the pack connection environment setting failure. Additionally, if the target power is within the range of 50% to 100% of the reference power amount and the link voltage is less than 90% of the pack voltage of the battery pack 10, the BMS 30 may determine that the capacitance of the link capacitor (221, referring to FIG. 3) is greater than the upper limit of the reference capacitance range or the pack connection environment setting failure.

In the step (S205), if the target power amount is greater than or equal to the reference power amount (No, at the step (S205)), the BMS 30 may determine whether the target power amount is less than 200% of the reference power amount (S206). Below, 200% of the reference power amount is an example of the second threshold power.

In the step (S206), if the target power amount is less than 200% of the reference power amount (Yes, at the step (S206)), the BMS 30 may diagnose the link capacitor 220 as a normal state in which pre-charge is normally performed (S207).

In the step (S206), if the target power amount is 200% or more of the reference power amount (No at the step (S206)), the BMS 30 may diagnose the status of the link capacitor 220 as a short circuit failure (S208).

Following the step (S203), following the step (S204), or following the step (S208), the BMS 30 may turn off the main relay 40 and the pre-charge relay 501 (S209).

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims

## Claims

1. A battery system comprising:
a battery pack;
two terminals connected to an external device including a link capacitor connected in parallel to the battery pack;
a pre-charge circuit including a pre-charge resistor and a pre-charge relay connected in series between one terminal of the battery pack and one of the two terminals;
a main relay connected in parallel to the pre-charge circuit; and
a battery management system (BMS) that measures a pack voltage of the battery pack and a link voltage between the two terminals, controls a turn-on operations of the pre-charge relay and the main relay, calculates a reference power amount estimated to have been supplied to the pre-charge resistor during a driving time of the pre-charge circuit, calculates a target power amount supplied to the pre-charge resistor during the driving time of the pre-charge circuit, and diagnoses a state of the link capacitor as one of a plurality of fault states based on a comparison result of the target power amount and a threshold power amount according to the reference power amount and a comparison result of the pack voltage and the link voltage.

2. The battery system of claim 1, wherein:
the BMS calculates the reference power amount based on a capacitance of the link capacitor, a resistance value of the pre-charge resistor, and the pack voltage during the driving time of the pre-charge circuit. .

3. The battery system of claim 1, further comprising a current sensor connected to one terminal of the pre-charge relay to measure a pre-charge current,
wherein the BMS calculates the target power amount based on the pack voltage and the pre-charge current flowing in the pre-charge relay during the driving time of the pre-charge circuit.

4. The battery system of claim 1, wherein:
the plurality of fault states include at least one of an open fault in which at least one of two wires between both terminals of the link capacitor and two terminals is open, a short-circuit fault in which at least one of the both terminals of the link capacitor is grounded, and a load failure in which a capacitance value of the link capacitor is smaller than or larger than a predetermined reference capacitance range,
if the status of the link capacitor is diagnosed as one of the plurality of fault states,
the BMS turns off the pre-charge relay and the main relay.

5. The battery system of claim 4, wherein:
if the target power amount is less than a first threshold power amount that is less than the reference power amount, and the link voltage is outside a predetermined reference voltage range based on the pack voltage,
the BMS diagnoses the status of the link capacitor as the open fault,

6. The battery system of claim 4, wherein:
if the target power amount is less than a first threshold power amount that is less than the reference power amount, and the link voltage is within a predetermined reference voltage range based on the pack voltage,
the BMS diagnoses the status of the link capacitor as the load failure, and diagnoses that the capacitance of the link capacitor is smaller than the lower limit of the reference capacitance range.

7. The battery system of claim 4, wherein:
if the target power amount is within a range of less than the reference power amount and greater than or equal to a first threshold power amount less than the reference power amount,
the BMS diagnoses the status of the link capacitor as the load failure.

8. The battery system of claim 7, wherein:
if the link voltage is within a predetermined reference voltage range based on the pack voltage,
the BMS diagnoses that the capacitance of the link capacitor is less than the lower limit of the reference capacitance range.

9. The battery system of claim 7, wherein:
if the link voltage is outside a predetermined reference voltage range based on the pack voltage,
the BMS diagnoses that the capacitance of the link capacitor is greater than the upper limit of the reference capacitance range.

10. A method for diagnosing a status of a link capacitor performed by a battery system, which includes a battery pack, two terminals connected to an external device including a link capacitor connected in parallel to the battery pack, a pre-charge circuit including a pre-charge resistor and a pre-charge relay connected in series between one terminal of the battery pack and one of the two terminals, a main relay connected in parallel to the pre-charge circuit, and a battery management system (BMS) controlling turn-on operations of the pre-charge relay and the main relay, comprising:
measuring a pack voltage of the battery pack;
measuring a link between the two terminals;
calculating a reference power amount estimated to have been supplied to the pre-charge resistor during a driving time of the pre-charge circuit;
calculating a target power amount supplied to the pre-charge resistor during the driving time of the pre-charge circuit; and
diagnosing a state of the link capacitor as one of a plurality of fault states based on a comparison result between the critical power amount according to the reference power amount and the target power amount and a comparison result between the pack voltage and the link voltage.

11. The method of claim 10, further comprising:
calculating the reference power amount based on a capacitance of the link capacitor, a resistance value of the pre-charge resistor, and the pack voltage during the driving time of the pre-charge circuit.

12. The method of claim 10, further comprising:
measuring a pre-charge current being connected to one terminal of the pre-charge relay; and
calculating the target power amount based on the pack voltage and the pre-charge current flowing in the pre-charge relay during the driving time of the pre-charge circuit.

13. The method of claim 10, wherein:
the plurality of fault states include at least one of an open fault in which at least one of two wires between both terminals of the link capacitor and two terminals is open, a short-circuit fault in which at least one of the both terminals of the link capacitor is grounded, and a load failure in which a capacitance value of the link capacitor is smaller than or larger than a predetermined reference capacitance range,
diagnosing the status of the link capacitor as one of the plurality of fault states includes
turning off the pre-charge relay and the main relay when the state of the link capacitor is diagnosed as one of the plurality of fault states.

14. The method of claim 13, further comprising:
if the target power amount is less than a first threshold power amount that is less than the reference power amount, and the link voltage is out of a predetermined reference voltage range based on the pack voltage, diagnosing the state of the link capacitor as the open fault.

15. The method of claim 13, further comprising
if the target power amount is less than a first threshold power amount that is less than the reference power amount, and the link voltage is within a predetermined reference voltage range based on the pack voltage, diagnosing the status of the link capacitor as the load failure, and diagnosing the capacitance of the link capacitor as being smaller than the lower limit of the reference capacitance range.

16. The method of claim 13, further comprising:
if the target power amount is within a range of less than the reference power amount and greater than or equal to a first threshold power amount less than the reference power amount, diagnosing the status of the link capacitor as the load failure.

17. The method of claim 16, further comprising:
if the link voltage is within a predetermined reference voltage range based on the pack voltage, diagnosing that the capacitance of the link capacitor is smaller than the lower limit of the reference capacitance range.

18. The method of claim 16, further comprising:
if the link voltage is outside a predetermined reference voltage range based on the pack voltage, diagnosing that the capacitance of the link capacitor is greater than the upper limit of the reference capacitance range.
